# EUROPÄISCHE PATENTSCHRIFT

(11) **EP 2 673 802 B1**
(45) Veröffentlichungstag und Bekanntmachung des Hinweises auf die Patenterteilung: **19.06.2019**
(21) Anmeldenummer: 12713583.8
(22) Anmeldetag: 09.02.2012
(51) Int. Cl.: H01L 23/31, H01L 23/498, H05K 3/34

(54) **VERGOSSENES BAUTEIL**
ENCAPSULATED COMPONENT
COMPOSANT ENROBÉ

(30) Priorität: 09.02.2011 DE 102011003832
(43) Veröffentlichungstag der Anmeldung: 18.12.2013
(73) Patentinhaber: Robert Bosch GmbH, 70442 Stuttgart (DE)
(72) Erfinder: VOGELGESANG, Michael, 71706 Markgröningen (DE)
(86) Internationale Anmeldenummer: PCT/EP2012/000594
(87) Internationale Veröffentlichungsnummer: WO 2012/107231

(56) Entgegenhaltungen:
- WO-A1-2005/071742
- JP-A- 6 152 141
- US-A1- 2001 040 280
- US-A1- 2002 140 095

## Beschreibung

### Stand der Technik

Die vorliegende Erfindung betrifft ein vergossenes Bauteil bzw. eine vergossene Baugruppe, nachfolgend als "Mold-Bauteil" bezeichnet, wie beispielsweise eine in eine Mold-Masse eingebettete Leiterplatte.

Mold-Bauteile sind aus dem Stand der Technik in unterschiedlichen Ausgestaltungen bekannt. Beim Einbetten des Bauteils in die Vergussmasse ergeben sich jedoch häufig Haftungsprobleme der Vergussmasse an freistehenden Leiterbahnen, insbesondere aus Kupfer bzw. des "Finalfinish" der Leiterplatte. Dies kann im Betrieb, insbesondere bei Temperaturwechsel, zu einer unerwünschten Überbeanspruchung des Mold-Bauteils führen, wodurch Risse o.ä. entstehen können.

WO 2005/071742 A1 zeigt ein Bauteil gemäß dem Oberbegriff des Anspruchs 1.

### Offenbarung der Erfindung

Das erfindungsgemäße Mold-Bauteil mit den Merkmalen des Anspruchs 1 weist demgegenüber den Vorteil auf, dass eine Vergussmasse problemlos an den Oberflächen des zu vergießenden Bauteils haftet. Dadurch kann insbesondere eine sehr hohe Lebensdauer des Mold-Bauteils sichergestellt werden. Dies wird erfindungsgemäß dadurch erreicht, dass alle elektronischen Bauelemente mittels eines Kontaktsockels am Bauteil kontaktiert sind. Hierdurch ist es möglich, dass das Bauteil eine äußerste Substratschicht aufweist, auf welcher die Vergussmasse sehr gut haftet. Ein elektrischer Kontakt zu elektronischen Bauelementen wird dann über einen Kontaktsockel (µVia-in-Land) bereitgestellt, welcher eine senkrechte Durchkontaktierung durch die äußerste Substratschicht ermöglicht. Das elektronische Bauelement ist dann auf einer äußeren Kontaktfläche des Kontaktsockels fixiert. Da erfindungsgemäß alle elektronischen Bauelemente mittels Kontaktsockeln kontaktiert sind, ist es möglich, dass das Bauteil keine freiliegenden Kupferflächen aufweist und somit eine Vergussmasse problemlos an der äußersten Substratschicht haften kann. Erfindungsgemäß ist der Kontaktsockel als Sackloch ausgebildet. Zwischen der freien Kontaktfläche des Kontaktsockels und dem elektronischen Bauelement ist eine Lötverbindung vorgesehen. Hierbei bedeckt ein Lot die Kontaktfläche des Lötsockels vollständig. Weiter weist der Kontaktsockel einen Verbindungsbereich auf, welcher als Hohlzylinder oder als Topf ausgebildet ist.

Die Unteransprüche zeigen bevorzugte Weiterbildungen der Erfindung.

Vorzugsweise weist der Kontaktsockel einen Durchmesser von kleiner oder gleich 150 µm auf. Hierdurch kann eine sehr dünne äußerste Substratschicht verwendet werden.

Das zu vergießende Bauteil ist vorzugsweise eine Leiterplatte, besonders bevorzugt eine mehrschichtige Leiterplatte.

Der Kontaktsockel ist vorzugsweise aus Kupfer hergestellt.

Bevorzugt umschließt die Vergussmasse das Mold-Bauteil vollständig.

Die Erfindung vorzugsweise bei Mold-Bauteilen für einen Automotive-Einsatz, beispielsweise bei Steuergeräten von Fahrzeugen, verwendet.

### Kurze Beschreibung der Zeichnung

Nachfolgend wird ein bevorzugtes Ausführungsbeispiel der Erfindung unter Bezugnahme auf die begleitende Zeichnung im Detail beschrieben. In der Zeichnung ist:
- Figur 1: eine schematische Schnittansicht eines Mold-Bauteils gemäß einem bevorzugten Ausführungsbeispiel der Erfindung,
- Figur 2: eine vergrößerte Teilausschnittsdarstellung von Figur 1, und
- Figur 3: eine Alternative des Kontaktsockels mit topfförmigem Verbindungsbereich.

### Bevorzugte Ausführungsform der Erfindung

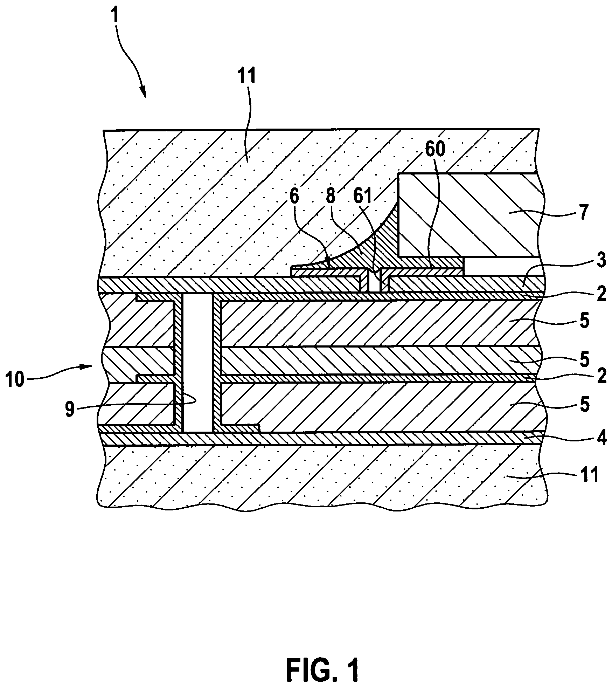

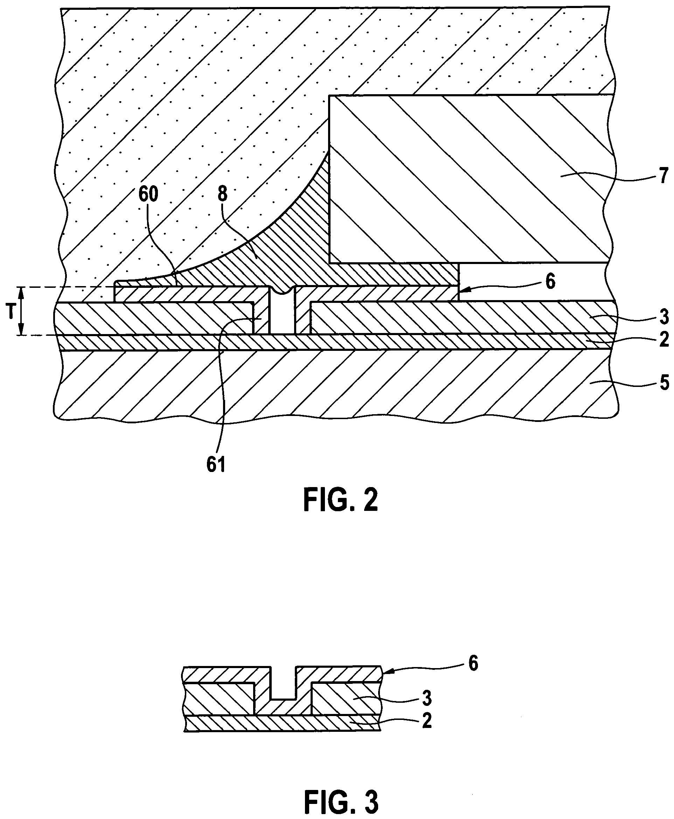

Nachfolgend wird unter Bezugnahme auf die Figur 1 und 2 ein Mold-Bauteil 1 gemäß einem Ausführungsbeispiel der Erfindung im Detail beschrieben.

Das Mold-Bauteil 1 umfasst eine bestückte Leiterplatte 10 und eine Vergussmasse 11, welche die Leiterplatte 10 vollständig einkapselt, um die Leiterplatte 10 zu schützen. Wie insbesondere aus Figur 1 ersichtlich ist, weist die Leiterplatte 10 einen schichtweisen Aufbau mit mehreren inneren Schichten 5 und mehreren Leiterbahnen 2 auf. Wie insbesondere aus Figur 1 ersichtlich ist, ist an der Leiterplatte 10 eine erste äußerste Substratschicht 3 und eine zweite äußerste Substratschicht 4 jeweils an der Oberseite und Unterseite der Leiterplatte vorgesehen. Unter der ersten äußersten Substratschicht 3 verläuft die Leiterbahn 2, welche über einen Kontaktsockel 6 durch die erste äußerste Substratschicht 3 durchkontaktiert ist. Der Kontaktsockel 6 ist als µVia-in-Land-Element gebildet und umfasst eine im Schnitt T-förmige Gestalt mit einer zur Außenseite der Leiterplatte freiliegenden Kontaktfläche 60 und einem senkrecht zur Kontaktfläche vorgesehenen Verbindungsbereich 61, der mit der Leiterbahn 2 in Kontakt steht. Der Verbindungsbereich 61 ist dabei hohlzylindrisch ausgebildet und die Kontaktfläche 60 weist eine Kreisform auf. Alternativ kann der Verbindungsbereich 61 auch als Topf 62 (Figur 3) ausgebildet sein und/oder die Kontaktfläche 60 eine beliebige Form, insbesondere eine Viereckform, aufweisen.

Ein elektronisches Bauelement 7 ist über eine Lötverbindung 8 auf den Kontaktsockel 6, genauer auf die Kontaktfläche 60 des Kontaktsockels aufgelötet. Der Kontaktsockel 6 bildet dabei eine Begrenzung für das Lot, so dass ein schneller und einfacher Lötvorgang ausgeführt werden kann. Insbesondere kann auf Lötstopplack verzichtet werden.

Wie aus Figur 2 ersichtlich ist, ist der Kontaktsockel 6 als Sacklochkontakt ausgebildet und stellt eine elektrische Verbindung zu einer äußersten Leiterbahn 2 bereit. Ein Durchmesser des sacklochartigen Kontaktsockels 6 ist kleiner oder gleich 150 µm und beträgt dabei vorzugsweise ungefähr 150 µm, und eine Tiefe T ist gleich oder kleiner als der Durchmesser.

Wie weiter aus Figur 2 ersichtlich ist, überdeckt die Lötverbindung 8 vollständig die Kontaktfläche 60, so dass es beim späteren Vergießen der Vergussmasse 11 keine Haftungsprobleme auf dem aus Kupfer hergestellten Kontaktsockel 6 gibt. Erfindungsgemäß sind dabei alle Kontakte zwischen den an der Außenseite der Leiterplatte 10 angeordneten elektronischen Bauelementen 7 und den Leiterbahnen 2 über Kontaktsockel 6 hergestellt. Dadurch wird eine hervorragende Haftung der Vergussmasse 11 auf den aus Substrat gebildeten Außenseiten der Leiterplatte ermöglicht.

Auch können durch das Vorsehen der beiden äußersten Substratschichten 3, 4 Durchkontaktierungen 9 abgedeckt werden.

Somit kann erfindungsgemäß ein Mold-Bauteil 1 mit einer signifikant verlängerten Lebensdauer bereitgestellt werden, wobei alle elektronischen Bauelemente 7 mit Kontaktsockeln 6 leitend verbunden sind. Erfindungsgemäß können dabei vollständig eingekapselte Mold-Bauteile bereitgestellt werden oder auch Mold-Bauteile, bei denen z.B. jeweils nur eine Seitenfläche eingekapselt ist.

## Patentansprüche

1. Mold-Bauteil, umfassend
- wenigstens eine Leiterbahn (2),
- wenigstens eine äußerste Substratschicht (3, 4), welche die Leiterbahn zu einer Außenseite hin überdeckt,
- wenigstens einen Kontaktsockel (6), welcher an einer Außenseite der äußersten Substratschicht (3, 4) angeordnet ist und eine Durchkontaktierung durch die äußerste Substratschicht (3, 4) zur Leiterbahn (2) bereitstellt,
- wenigstens ein elektronisches Bauelement (7), welches auf dem Kontaktsockel (6) kontaktiert ist, und
- eine Vergussmasse (11), welche das Mold-Bauteil zumindest teilweise von außen umschließt,
- wobei alle elektronischen Bauelemente (7) mittels Kontaktsockeln (6) kontaktiert sind,- wobei der Kontaktsockel (6) als Sacklochkontakt vorgesehen ist,
- eine Lötverbindung (8) zwischen dem Kontaktsockel (6) und dem elektronischen Bauelement (7),
**dadurch gekennzeichnet, dass**
- der Kontaktsockel (6) einen Verbindungsbereich (61) aufweist, welcher hohlzylindrisch oder topfförmig ausgebildet ist, und ein Lot zur Befestigung des elektronischen Bauelements (7) eine Kontaktfläche (60) des Kontaktsockels (6) vollständig überdeckt.

2. Mold-Bauteil nach Anspruch 1, **dadurch gekennzeichnet, dass** der Kontaktsockel (6) einen Durchmesser von kleiner oder gleich 150 µm aufweist und/oder eine Tiefe (T), welche kleiner oder gleich dem Durchmesser des Kontaktsockels (6) ist.

3. Mold-Bauteil nach einem der vorhergehenden Ansprüche, **dadurch gekennzeichnet, dass** die Vergussmasse (11) das Mold-Bauteil vollständig umschließt.

4. Mold-Bauteil nach einem der vorhergehenden Ansprüche, umfassend eine mehrschichtige Leiterplatte.

## Claims

1. Moulded part, comprising
- at least one conductor track (2),
- at least one outermost substrate layer (3, 4) that covers the conductor track towards an outer side,
- at least one contact base (6) that is arranged on an outer side of the outermost substrate layer (3, 4) and provides a through-connection through the outermost substrate layer (3, 4) to the conductor track (2),
- at least one electronic component (7) with which contact is made on the contact base (6), and
- an encapsulation material (11) that at least partly externally encloses the moulded part,
- wherein contact is made with all of the electronic components (7) by way of contact bases (6),
- wherein the contact base (6) is provided in the form of a blind hole contact,
- a solder connection (8) between the contact base (6) and the electronic component (7),
**characterized in that**
- the contact base (6) has a connection region (61) that is designed as a hollow cylinder or in a pot shape, and
- a solder for fastening the electronic component (7) completely covers a contact surface (60) of the contact base (6).

2. Moulded part according to Claim 1, **characterized in that** the contact base (6) has a diameter of less than or equal to 150 µm and/or a depth (T) that is less than or equal to the diameter of the contact base (6).

3. Moulded part according to either of the preceding claims, **characterized in that** the encapsulation material (11) completely encloses the moulded part.

4. Moulded part according to one of the preceding claims, comprising a multilayer circuit board.

## Revendications

1. Élément structural moulé, comprenant
- au moins une piste conductrice (2),
- au moins une couche de substrat la plus à l'extérieur (3, 4) qui recouvre la piste conductrice en direction d''un côté extérieur,
- au moins un socle de contact (6) qui est disposé au niveau d'un côté extérieur de la couche de substrat la plus à l'extérieur (3, 4) et réalise une mise en contact traversante à travers la couche de substrat la plus à l'extérieur (3, 4) vers la piste conductrice (2),
- au moins un composant électronique (7) qui est mis en contact sur le socle de contact (6) et
- une masse de scellement (11) qui entoure au moins partiellement l'élément structural moulé depuis l'extérieur,
- le contact avec tous les composants électroniques (7) étant établi au moyen de socles de contact (6), le socle de contact (6) étant conçu sous la forme d'un contact à trou borgne,
- une liaison brasée (8) entre le socle de contact (6) et le composant électronique (7),
**caractérisé en ce que**
- le socle de contact (6) possède une zone de liaison (61) qui est de configuration cylindrique creuse ou en forme de pot, et
un brasage destiné à fixer le composant électronique (7) recouvre entièrement une surface de contact (60) du socle de contact (6).

2. Élément structural moulé selon la revendication 1, **caractérisé en ce que** le socle de contact (6) possède un diamètre inférieur ou égal à 150 µm et/ou une profondeur (T) qui est inférieure ou égale au diamètre du socle de contact (6).

3. Élément structural moulé selon l'une des revendications précédentes, **caractérisé en ce que** la masse de scellement (11) entoure entièrement l'élément structural moulé.

4. Élément structural moulé selon l'une des revendications précédentes, comprenant un circuit imprimé multicouche.
